(19) Europäisches Patentamt
European Patent Office
Office européen des brevets

(11) **EP 4 648 244 A1**

(12) **EUROPEAN PATENT APPLICATION**
published in accordance with Art. 153(4) EPC

(43) Date of publication:
**12.11.2025 Bulletin 2025/46**

(21) Application number: **24762927.2**

(22) Date of filing: **25.01.2024**

(51) International Patent Classification (IPC):
**H02J 1/08** (2006.01)     **H04L 12/10** (2006.01)

(52) Cooperative Patent Classification (CPC):
**G01R 19/00; G01R 27/02; H02H 11/00; H02J 1/08;
H02J 13/00; H04L 12/10**

(86) International application number:
**PCT/CN2024/074044**

(87) International publication number:
**WO 2024/179244 (06.09.2024 Gazette 2024/36)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.02.2023 CN 202310225191**

(71) Applicant: **Huawei Technologies Co., Ltd.
Shenzhen, Guangdong 518129 (CN)**

(72) Inventors:
• **LI, Bing**
  **Shenzhen, Guangdong 518129 (CN)**
• **WANG, Li**
  **Shenzhen, Guangdong 518129 (CN)**
• **QIAN, Xin**
  **Shenzhen, Guangdong 518129 (CN)**

(74) Representative: **MERH-IP Matias Erny Reichl
Hoffmann
Patentanwälte PartG mbB
Paul-Heyse-Straße 29
80336 München (DE)**

(54) **POWER SOURCING EQUIPMENT AND POWER SOURCING METHOD**

(57) Embodiments of this application disclose power sourcing equipment and a power supply method. The power sourcing equipment may include a PSE chip, a first anti-reverse circuit, a second anti-reverse circuit, and a PoF connector. The PSE chip includes a first PSE channel and a second PSE channel. The PoF connector includes a positive contact and a negative contact. A powered device PD is connected between the positive contact and the negative contact. The first PSE channel is connected to the negative contact through the first anti-reverse circuit, and the second PSE channel is connected to the negative contact through the second anti-reverse circuit. When the first PSE channel performs first voltage detection on the PD, the second PSE channel is pulled up to a positive electrode of a power supply source by using an internal pull-up resistor R2, where R2 is equivalent to being connected in parallel with the PD, and the second anti-reverse circuit is in a state of being conducted from the negative contact to the second PSE channel and being blocked from R2 to the negative contact. In this application, power supply stability of the power sourcing equipment can be improved.

[FIG. 10]

**Description**

This application claims priority to Chinese Patent Application No. 202310225191.0, filed with the China National Intellectual Property Administration on February 28, 2023 and entitled "POWER SOURCING EQUIPMENT AND POWER SUPPLY METHOD", which is incorporated herein by reference in its entirety.

TECHNICAL FIELD

This application relates to the field of power over fiber (Power over Fiber, PoF) technologies, and in particular, to power sourcing equipment and a power supply method.

BACKGROUND

In live access network deployment, an end device (for example, a radio access point (Access Point, AP) or a camera) and an access gateway device usually need to be far away from each other based on an actual scenario requirement. If the end device cannot be deployed at a location to obtain power locally, the access gateway usually needs to provide both a communication function and a remote power supply function. There are two frequently-used remote power supply manners:

Manner 1: Network cable + power over Ethernet (Power over Ethernet, PoE). The network cable carries both the communication function and the power supply function. Due to a higher requirement of a bandwidth capability on the network cable, a size, a weight, and costs of the network cable are gradually increasing, resulting in a bottleneck for live network deployment.

Manner 2: Optical and electrical hybrid cable + PoE. An optical fiber in the hybrid cable carries communication, which breaks through a bandwidth bottleneck for a network cable. A copper wire in the hybrid cable carries power supply, which still complies with a PoE protocol.

The power over Ethernet PoE includes power sourcing equipment (Power sourcing equipment, PSE) and a powered device (Powered Device, PD). The PoE is a wired power over Ethernet technology, and is a technology that is most widely used in a local area network currently. The PoE allows electric power and data to be coupled and to be transmitted, through a cable, to each terminal device for an operation, or may separately transmit electric power and data to the terminal device. With development of the PoE standard, IEEE 802.3af (PoE), IEEE 802.3at (PoE+), and IEEE 802.3bt (PoE++) have been released. PoE++ may provide a power supply capability of up to 90 w.

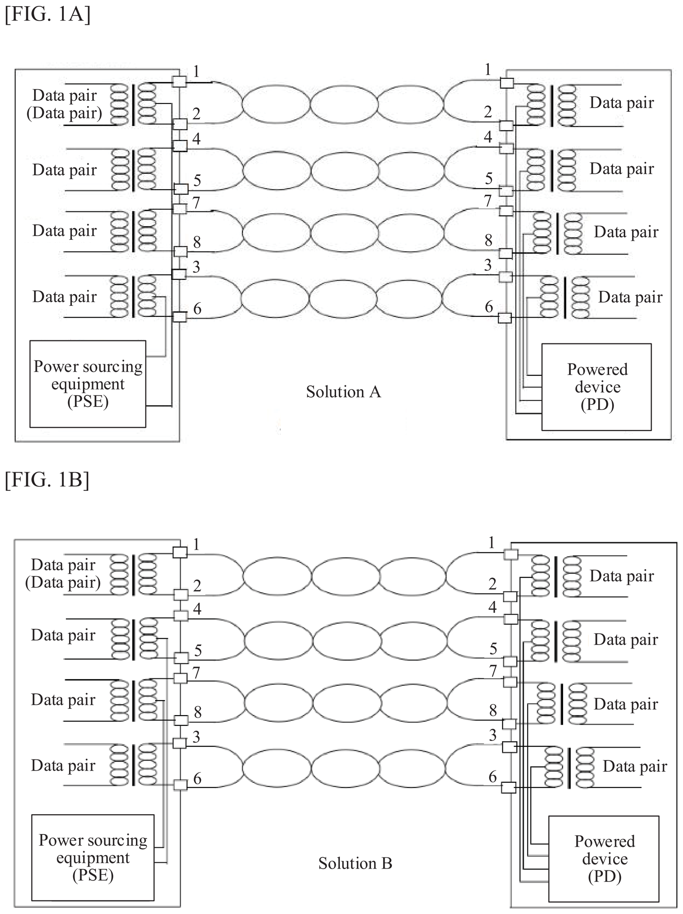

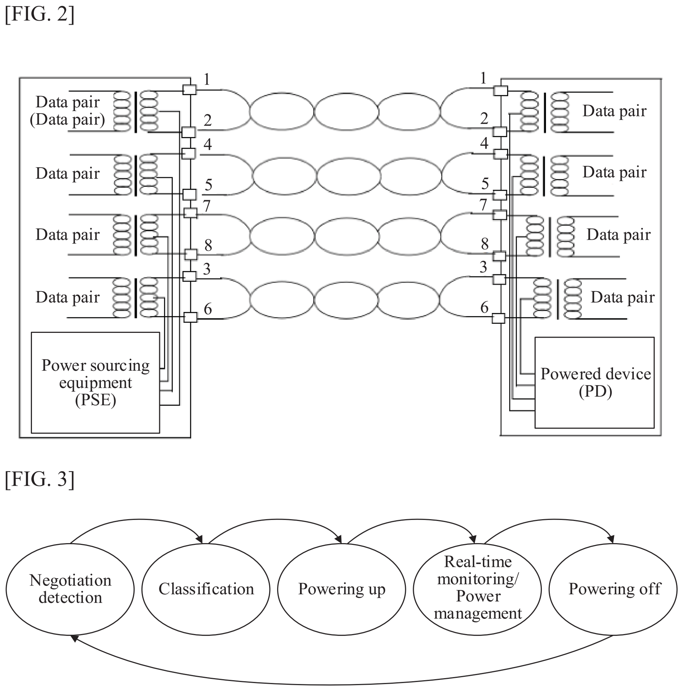

In the foregoing manner 1, a PoE model is completed in combination with four pairs in the network cable, and the PSE and the PD perform transmission of electric power through a loop formed by the pairs. FIG. 1A is a schematic of a PoE/PoE+ power supply model in the conventional technology. FIG. 1B is a schematic of another PoE/PoE+ power supply model in the conventional technology. There are two power supply modes for PSE depending on different used power supply pairs: an alternative solution A (Alternative A) (pairs 1/2 and 3/6) and an alternative solution B (Alternative B) (pairs 4/5 and 7/8). In the PoE and PoE+ standards, a maximum power is 30 w, and only two pairs: (network cables 1 and 2 + network cables 3 and 6) shown in FIG. 1A or (network cables 4 and 5 + network cables 7 and 8) shown in FIG. 1B, need to be used for power supply between the PSE and the PD. In the PoE++ standard, a maximum of 90 w power may be provided. FIG. 2 is a schematic of a PoE++ power supply model in the conventional technology. Considering a through-current capability of a single pair, four pairs (network cables 1 and 2 + network cables 3 and 6 and network cables 4 and 5 + network cables 7 and 8) need to be used for power supply between the PSE and the PD.

In the foregoing manner 2, the power supply of the optical and electrical hybrid cable still complies with PoE-related protocols (including PoE, PoE+, and PoE++) of the power over Ethernet. The power supply is implemented by the copper wire in the optical and electrical hybrid cable, and transmission of a signal is performed through the optical fiber in the optical and electrical hybrid cable. There is a big difference between a structure of the optical and electrical hybrid cable and a structure of the network cable, causing a power supply failure, a problem of power supply stability, and other problems in some actual power supply scenarios.

SUMMARY

Embodiments of this application provide power sourcing equipment and a power supply method, to improve power supply stability of the power sourcing equipment.

According to a first aspect, an embodiment of this application provides power sourcing equipment, where the power sourcing equipment may include a power sourcing equipment PSE chip, a first anti-reverse circuit, a second anti-reverse circuit, and a power over fiber PoF connector. The PSE chip includes a first PSE channel and a second PSE channel. The PoF connector includes a positive contact and a negative contact, and a powered device PD connected to the PoF connector is connected between the positive contact and the negative contact. The first PSE channel is connected to the negative contact through the first anti-reverse circuit, and the second PSE channel is connected to the negative contact through the second anti-reverse circuit, where a reverse direction of the first anti-reverse circuit is connected to the first PSE channel, a forward direction of the first anti-reverse circuit is connected to the negative contact, a reverse direction of the second anti-reverse circuit is connected to the second PSE channel, and a forward direction of the second anti-reverse circuit is connected to the negative contact. The positive contact is connected to a positive output end of a power supply source. When the first PSE channel performs first voltage detection on the PD, the second PSE channel is pulled up to a positive electrode of the power supply source by using an internal pull-up resistor R2, where R2 is equivalent to being connected in parallel with the PD, and the second anti-reverse circuit is in a state of being conducted from the negative contact to the second PSE channel and being blocked from R2 to the negative contact.

In a power over fiber (Power over Fiber, PoF) application scenario, a plurality of PSE channels (for example, the first PSE channel and the second PSE channel) of the PSE chip in the power sourcing equipment supply power to the powered device. For a hardware structure, the first PSE channel and the second PSE channel are connected to a same negative contact of the PoF connector. Therefore, when negotiation detection is performed on the powered device, because an idle channel (for example, when the first PSE channel performs negotiation, the second PSE channel is an idle channel; or when the second PSE channel performs negotiation, the first PSE channel is an idle channel) introduces a pull-up resistor, resistance measurement of a negotiation channel for the powered device is inaccurate. That is, in a negotiation detection process of power supply, a resistance detection error is caused due to short-circuited and converged PSE channels, which may cause a final negotiation detection failure. In the power sourcing equipment provided in this embodiment of this application, anti-reverse circuits (for example, the first anti-reverse circuit and the second anti-reverse circuit) are separately added between the first PSE channel, the second PSE channel, and the PoF connector, so that when the PSE chip is in a phase of performing negotiation detection on the powered device, forward conduction and reverse blocking can be implemented through the anti-reverse circuits. In this way, when the negotiation channel (for example, the first PSE channel) performs negotiation detection on the powered device, the pull-up resistor in the idle channel (for example, the second PSE channel) cannot be connected to the circuit in a reverse direction due to disposing of the anti-reverse circuit, thereby avoiding impact of the pull-up resistor on the negotiation channel detection, improving accuracy of the detection performed by the power sourcing equipment in the negotiation detection phase, and avoiding a power supply failure. This helps improve power supply stability of the power sourcing equipment.

In a possible implementation, when the second PSE channel performs second voltage detection on the PD, the first PSE channel is pulled up to the positive electrode of the power supply source by using an internal pull-up resistor R1, where R1 is equivalent to being connected in parallel with the PD, and the first anti-reverse circuit is in a state of being conducted from the negative contact to the first PSE channel and being blocked from R1 to the negative contact.

In the power sourcing equipment provided in this embodiment of this application, anti-reverse circuits (for example, the first anti-reverse circuit and the second anti-reverse circuit) are separately added between the first PSE channel, the second PSE channel, and the PoF connector, so that when the PSE chip is in a phase of performing negotiation detection on the powered device, forward conduction and reverse blocking can be implemented through the anti-reverse circuits. In this way, when the negotiation channel (for example, the second PSE channel) performs negotiation detection on the powered device, the pull-up resistor in the idle channel (for example, the first PSE channel) cannot be connected to the circuit in a reverse direction due to disposing of the anti-reverse circuit, thereby avoiding impact of the pull-up resistor on the negotiation channel detection, and improving accuracy of the detection performed by the power sourcing equipment in the negotiation detection phase. This helps improve power supply stability of the power sourcing equipment.

In a possible implementation, each of the first anti-reverse circuit and the second anti-reverse circuit is an anti-reverse circuit including a diode, where the forward directions of the first anti-reverse circuit and the second anti-reverse circuit each are an anode of the diode, and the reverse directions of the first anti-reverse circuit and the second anti-reverse circuit each are a cathode of the diode. Each of the anti-reverse circuits in this embodiment of this application includes a diode, and unidirectional conduction between the PSE channel and the PoF connector is implemented based on unidirectional conductivity performance of the diode. An anode of the diode is used as a forward direction of the anti-reverse circuit, and a cathode of the diode is used as a reverse direction of the anti-reverse circuit.

In a possible implementation, each of the first anti-reverse circuit and the second anti-reverse circuit is an anti-reverse circuit including a metal-oxide-semiconductor MOS transistor, where the forward directions of the first anti-reverse circuit and the second anti-reverse circuit each are a source of the MOS transistor, and the reverse directions of the first anti-reverse circuit and the second anti-reverse circuit each are a drain of the diode. Each of the anti-reverse circuits in this embodiment of this application includes an MOS transistor. Unidirectional conduction between the PSE channel and the PoF connector is implemented based on a characteristic that the MOS transistor is conducted when a power supply is normally connected, and the MOS transistor is blocked when the power supply is reversely connected. A source of the MOS transistor is used as a forward direction of the anti-reverse circuit, and a drain of the MOS transistor is used as a reverse direction of the anti-reverse circuit.

In a possible implementation, the first anti-reverse circuit or the second anti-reverse circuit further includes one or more of a voltage divider resistor, a current-limiting resistor, and a regulator diode that are connected to the MOS transistor. In this embodiment of this application, when each of the anti-reverse circuits includes an MOS transistor, alternatively, one or more of a related voltage divider resistor, a related current-limiting resistor, and a related regulator diode may be disposed in the anti-reverse circuit, to stabilize a voltage on the MOS transistor, so as to better implement a unidirectional conduction function.

In a possible implementation, the first PSE channel and the second PSE channel form one group of power supply channels, and the power supply channel is configured to perform detection, classification, powering up, monitoring, or power management on the PD. In this embodiment of this application, power is supplied to the powered device through the power supply channels that include the first PSE channel and the second PSE channel. Further, related functions such as negotiation detection, classification, powering up, monitoring, or power management may be provided for the powered device.

In a possible implementation, the power supply source is configured to provide an initial voltage between the positive contact and the negative contact. The first PSE channel is configured to regulate the initial voltage between the positive contact and the negative contact to a first detection voltage. Alternatively, the second PSE channel is configured to regulate the initial voltage between the positive contact and the negative contact to a second detection voltage. In this embodiment of this application, in the negotiation detection phase in which power is supplied to the powered device, corresponding detection voltages are separately provided for the powered device through the first PSE channel and the second PSE channel, to obtain a detection resistance of the powered device through measurement.

In a possible implementation, the PSE chip further includes a plurality of groups of power supply channels, and each group of power supply channels include at least the first PSE channel and the second PSE channel. The power sourcing equipment further includes a first anti-reverse circuit, a second anti-reverse circuit, and a power over fiber PoF connector that correspond to each group of power supply channels. In this embodiment of this application, the PSE chip may include a plurality of PSE channels, and at least two PSE channels form one group of power supply channels to supply power to the corresponding power sourcing equipment. In addition, correspondingly, the first PSE channel and the second PSE channel in each of the plurality of groups of power supply channels are also connected to a corresponding first anti-reverse circuit and second anti-reverse circuit, and a corresponding PoF connector.

According to a second aspect, an embodiment of this application provides a power supply method. The power supply method may be applied to power sourcing equipment, where the power sourcing equipment may include a power sourcing equipment PSE chip, a first anti-reverse circuit, a second anti-reverse circuit, and a power over fiber PoF connector. The PSE chip includes a first PSE channel and a second PSE channel. The PoF connector includes a positive contact and a negative contact, and a powered device PD connected to the PoF connector is connected between the positive contact and the negative contact. The first PSE channel is connected to the negative contact through the first anti-reverse circuit, and the second PSE channel is connected to the negative contact through the second anti-reverse circuit, where a reverse direction of the first anti-reverse circuit is connected to the first PSE channel, a forward direction of the first anti-reverse circuit is connected to the negative contact, a reverse direction of the second anti-reverse circuit is connected to the second PSE channel, and a forward direction of the second anti-reverse circuit is connected to the negative contact. The positive contact is connected to a positive output end of a power supply source. The method includes: when the first PSE channel performs first voltage detection on the PD, controlling the second PSE channel to be pulled up to a positive electrode of the power supply source by using an internal pull-up resistor R2, where R2 is equivalent to being connected in parallel with the PD, to enable the second anti-reverse circuit to be in a state of being conducted from the negative contact to the second PSE channel and being blocked from R2 to the negative contact; and when the second PSE channel performs second voltage detection on the PD, controlling the first PSE channel to be pulled up to the positive electrode of the power supply source by using an internal pull-up resistor R1, where R1 is equivalent to being connected in parallel with the PD, to enable the first anti-reverse circuit to be in a state of being conducted from the negative contact to the first PSE channel and being blocked from R1 to the negative contact.

According to a third aspect, an embodiment of this application provides a power supply system, where the power supply system may include the power sourcing equipment PSE and the powered device PD in any one of the implementations of the first aspect.

The power sourcing equipment PSE supplies power to the powered device, the power sourcing equipment PSE is a network switch or an optical network unit ONU, and the powered device PD is a camera, an internet protocol IP telephone, a fax machine, or a radio access point AP.

According to a fourth aspect, this application provides a system-on-chip SoC chip. The SoC chip includes the power sourcing equipment provided in any one of the implementations of the first aspect, and an internal memory and an external memory that are coupled to the power sourcing equipment. The SoC chip may include a chip, or may include a chip and another discrete device.

According to a fifth aspect, this application provides a chip system, where the chip system includes the power sourcing equipment provided in any one of the implementations of the first aspect. In a possible design, the chip system further includes a memory, and the memory is configured to store necessary or related program instructions and data in a running process of the power sourcing equipment. The chip system may include a chip, or may include a chip and another discrete device.

According to a sixth aspect, this application provides a power supply apparatus. The power supply apparatus has a function of implementing any one of the power supply methods according to the first aspect. The function may be implemented by hardware, or may be implemented by hardware executing corresponding software. The hardware or the software includes one or more modules corresponding to the function.

According to a seventh aspect, this application provides a computer-readable storage medium. The computer-readable storage medium stores a computer program, and when the computer program is executed by power sourcing equipment, the power supply method procedure according to any one of the implementations of the second aspect is implemented.

According to an eighth aspect, an embodiment of this application provides a computer program. The computer program includes instructions, and when the instructions are executed by power sourcing equipment, the power sourcing equipment is enabled to perform the power supply method procedure according to any one of the implementations of the second aspect.

BRIEF DESCRIPTION OF DRAWINGS

To describe the technical solutions in embodiments of this application or in the background more clearly, the following describes the accompanying drawings for describing embodiments of this application or the background.

FIG. 1A is a schematic of a PoE/PoE+ power supply model in the conventional technology;
FIG. 1B is a schematic of another PoE/PoE+ power supply model in the conventional technology;
FIG. 2 is a schematic of a PoE++ power supply model in the conventional technology;
FIG. 3 is a diagram of a PoE procedure according to an embodiment of this application;
FIG. 4 is an equivalent circuit schematic in which PSE supplies power to a PD according to an embodiment of this application;
FIG. 5 is a diagram of valid signature resistance detection parameters of PSE and a PD according to an embodiment of this application;
FIG. 6 is a schematic of a detection sequence of a PoE++ single-signature PD according to an embodiment of this application;
FIG. 7 is a schematic of an 802.3bt power supply connection of an Ethernet interface according to an embodiment of this application;
FIG. 8 is a schematic of an 802.3bt power supply connection of an optical and electrical hybrid cable according to an embodiment of this application;
FIG. 9 is a schematic of a PoE network deployment topology according to an embodiment of this application;
FIG. 10 is a schematic of a power supply connection in a PoF system according to an embodiment of this application;
FIG. 11 is another schematic of a power supply connection in a PoF system according to an embodiment of this application;
FIG. 12A is a schematic of a structure of a diode anti-reverse circuit according to an embodiment of this application;
FIG. 12B is a schematic of a structure of an MOS transistor anti-reverse circuit according to an embodiment of this application; and
FIG. 13 is a schematic flowchart of a power supply method according to an embodiment of this application.

DESCRIPTION OF EMBODIMENTS

The following describes embodiments of this application with reference to the accompanying drawings in embodiments of this application.

In the specification, claims, and accompanying drawings of this application, terms such as "first", "second", "third", and "fourth" are intended to distinguish between different objects rather than indicate a particular order. In addition, the terms "including", "having", and any other variants thereof are intended to cover non-exclusive inclusion. For example, a process, a method, a system, a product, or a device that includes a series of steps or units is not limited to the listed steps or units, but optionally further includes an unlisted step or unit, or optionally further includes another step or unit inherent to the process, the method, the product, or the device.

Mentioning an "embodiment" in this specification means that a particular feature, structure, or characteristic described with reference to embodiments may be included in at least one embodiment of this application. The phrase shown in various locations in the specification may not necessarily refer to a same embodiment, and is not a separate or alternative embodiment exclusive from another embodiment. It is explicitly and implicitly understood by persons skilled in the art that embodiments described in the specification may be combined with another embodiment.

Terms such as "component", "module", and "system" used in this specification indicate a computer-related entity, hardware, firmware, a combination of hardware and software, software, or software being executed. For example, the component may be, but is not limited to, a process that is run on a processor, a processor, an object, an executable file, an execution thread, a program, and/or a computer. As illustrated by using figures, both a computing device and an application that is run on the computing device may be components. One or more components may reside within a process and/or an execution thread, and the components may be located on one computer and/or distributed between two or more computers. In addition, these components may be executed by various computer-readable media that store various data structures. For example, the components may communicate by using a local and/or remote process and based on a signal having one or more data packets (for example, data from two components interacting with another component in a local system, a distributed system, and/or across a network such as the Internet interacting with other systems by using the signal).

Some terms in this application are first described, to facilitate understanding for persons skilled in the art.

(1) Power over fiber (Power over Fiber, PoF) provides both data transmission and power supply functions through one optical and electrical hybrid cable, to resolve problems of limited bandwidth and remote power supply. The optical and electrical hybrid cable is applicable to a broadband access network system to be used as a transmission line. As a new access manner, the photoelectric composite cable integrates optical fibers and power transmission copper wires to resolve problems of broadband access, device power consumption, and signal transmission. For example, the optical fiber is an optical signal receiving interface, and the copper wire is a power interface.

(2) A pull-up resistor is to pull up an interface line to a positive voltage by using a resistor. Pulling up is to clamp an uncertain signal at a high level by using a resistor, and the resistor has a current-limiting function.

(3) An alternating current (Alternating Current, AC) is referred to as an alternating current or an alternating current for short. A direct current (Direct Current, DC) is referred to as a direct current or a direct current for short.

(4) A metal-oxide-semiconductor field-effect transistor (Metal-Oxide-Semiconductor Field-Effect Transistor, MOSFET) is referred to as an MOS transistor for short. Three electrodes of the MOS transistor are G for gate (gate), S for source (source), and D for drain (drain). The source (source) and the drain (drain) of the MOS transistor can be interchanged, and are both N-type regions formed in a P-type backgate. The MOS transistor is classified into a PMOS transistor (P-channel type) and an NMOS transistor (N-channel type), which are insulated gate field-effect transistors.

(5) A diode has a unidirectional conduction characteristic. Specifically, the diode has a characteristic of forward conduction and reverse blocking. When a positive voltage is applied to a positive end (positive electrode) of the diode, and a negative voltage is applied to a negative end (negative electrode), the diode is conducted, and a current flows through the diode. When a negative voltage is applied to a positive end (positive electrode) of the diode, and a positive voltage is applied to a negative end (negative electrode), the diode is blocked, and no current flows through the diode.

First, for ease of understanding embodiments of this application, a technical problem specifically to be resolved in this application is further proposed and analyzed. In the conventional technology, when a powered device PD accesses a power sourcing equipment PSE system, a procedure of obtaining a power supply by the powered device is shown in FIG. 3. FIG. 3 is a diagram of a PoE procedure according to an embodiment of this application. The procedure mainly includes several phases such as negotiation detection, classification, powering up, real-time monitoring, power management, and disconnection. A next phase is entered only after a previous phase is completed. The first step of negotiation detection is an important function in a PoE system, and determines whether a remote device connected to PSE has a capability of receiving power (that is, determines whether the remote device is the PD). A most basic detection manner is resistance detection. The following lists common resistance detection solutions as an example. This is specifically as follows:

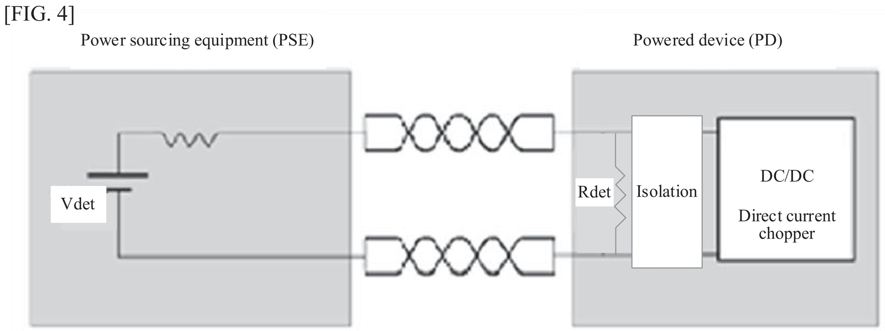

1. FIG. 4 is an equivalent circuit schematic in which PSE supplies power to a PD according to an embodiment of this application. The PSE provides two different voltages V1 and V2 that are between 2.7 V and 10.1 V to the PD (to ensure that the connected device is not damaged by a voltage output by the PSE). The PD identifies the detection voltage, and enables a characteristic resistance Rsig to be detected by the PSE. The PSE samples the detection voltage and a corresponding current and performs calculation, that is, ∆V/∆I, to obtain a resistance Rdet at a PD port. A formula for calculating the resistance Rdet is specifically as follows:

$$R_{detect} = \frac{V_{detect1} - V_{detect2}}{I_{detect1} - I_{detect2}}$$

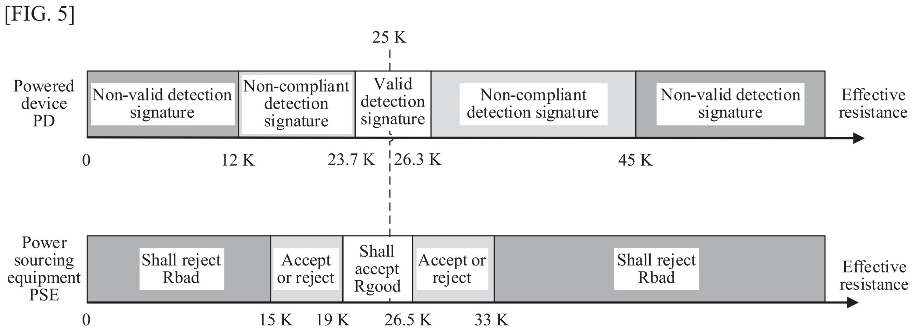

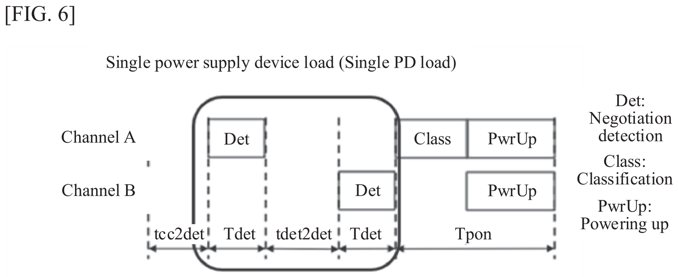

2. If the resistance of the PD is presented as a resistance value about 25 kilohms, the detection succeeds (a difference between two test points is greater than 1 V). Valid signature resistance detection parameters of the PSE and the PD are shown in FIG. 5. FIG. 5 is a diagram of valid signature resistance detection parameters of PSE and a PD according to an embodiment of this application. A white zone indicates a range of a signature resistance (valid detection signature) in an accepted standard, a light gray zone is a range of a signature resistance (non-compliant detection signature (Non-compliant detection signature)) of a non-standard PoE device, and a dark gray zone is a range of rejecting a signature resistance (non-valid detection signature (Non-valid detection signature)). Correspondingly, policies for a power sourcing equipment PSE end are as follows: shall accept (shall accept), accept or reject (accept or reject), and shall reject (shall reject). FIG. 6 is a schematic of a detection sequence of a PoE++ single-signature PD according to an embodiment of this application. It should be noted that the foregoing signature resistance detection is performed on both PoE++ and PoE/PoE+. A difference is as follows: Because four pairs (two pairs are connected to a positive electrode, and two pairs are connected to a negative electrode) are used for PoE++, two times of detection is separately performed (FIG. 6 shows one mode), that is, there are four twisted pairs for PSE output power, and in a detection phase, a total of two times of detection needs to be independently performed on the two pairs (namely, two twisted pairs) that are connected to the negative electrode. For example, in FIG. 6, a negotiation detection procedure (Det) is first performed on one pair Alt-A (network cables 1 and 2), and then a negotiation detection procedure is performed on the other pair Alt-B (network cables 7 and 8), that is, negotiation detection is performed on the two pairs separately in different time periods (Tdet). Subsequently, classification (Class), powering up (PwrUP), and the like may be performed in another time period (for example, Tpon) based on a negotiation detection result.

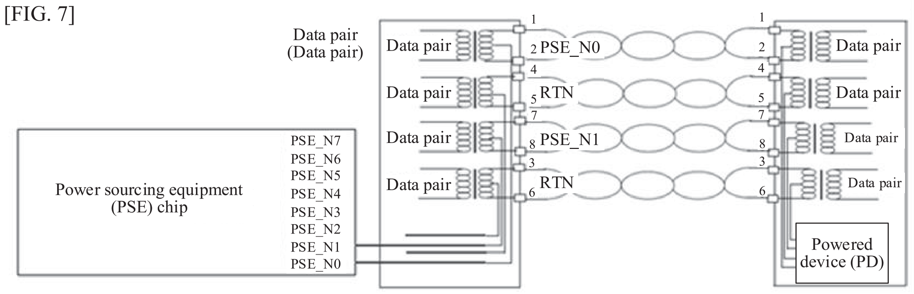

3. Power supply of an optical and electrical hybrid cable still complies with a PoE protocol of a network cable. An optical and electrical hybrid cable interface of a gateway & power supply unit device uses two manners: a specific optical and electrical hybrid cable connector (for example, optical and electrical hybrid cable + connector), for example, a Hybrid SC/XC, and an optical and electrical hybrid cable module (for example, optical and electrical hybrid cable + specific optical module), and is matched with an external optical and electrical hybrid cable, to implement optical-electrical integration. A specification needs to meet a power supply capability of 802.3bt (PoE++). In a case of an Ethernet cable, four pairs of cables (two pairs are used as positive cables and two pairs are used as negative cables) need to be used to separately supply power, and are physically isolated. The following uses an 8-channel PSE chip as an example. FIG. 7 is a schematic of an 802.3bt power supply connection of an Ethernet interface according to an embodiment of this application. PSE N0 (network cables 1 and 2) and PSE N1 (network cables 7 and 8) are connected to a same negative end, and a pair including network cables 4 and 5 and a pair including network cables 3 and 6 are connected to a same positive end, that is, a positive electrode (RTN) of a power supply source.

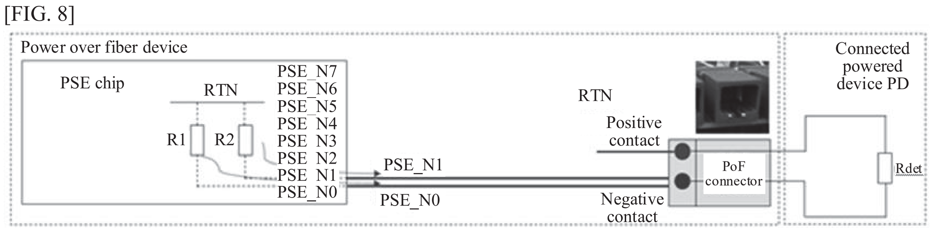

For the optical and electrical hybrid cable, considering factors such as a size and a weight of the cable, usually, only two copper wires (one is used as a positive wire and the other one is used as a negative wire) are connected to two power supply contacts on the connector or the module, to supply power. In this case, two channels: a PSE_N0 channel and a PSE_N1 channel of the PSE chip are short-circuited and converged at a negative contact of the external connector. FIG. 8 is a schematic of an 802.3bt power supply connection of an optical and electrical hybrid cable according to an embodiment of this application. In an 802.3bt mode, two PSE channels (for example, the PSE_N0 and the PSE_N1) of the PSE separately perform negotiation detection steps (as described in the foregoing related descriptions in FIG. 6), that is, two PSE channels in one group of power supply channels perform negotiation detection twice in total, and each of the two PSE channels performs detection once. When one PSE channel performs negotiation detection, the other idle PSE channel is internally pulled up to the positive electrode RTN of the power supply source. However, because the channels are short-circuited at the connector contact (for example, a negative electrode), an internal pull-up state of the idle PSE channel affects negotiation of the working PSE channel. As a result, a deviation of a detection resistance of the working PSE channel is large and exceeds a range specified in a protocol, causing a problem that negotiation cannot be performed probabilistically. Consequently, power cannot be supplied to a lower-level PD. For example, in a normal negotiation case, a detected negotiation resistance should be Rdet. However, actually, during PSE_N0 channel negotiation, the PSE_N1 is internally pulled up to the positive electrode RTN of the power supply source by using an R2. In this case, due to impact of the internal pull-up resistor and the external short-circuit between the PSE_NO and the PSE_N1 through the connector contact, actually, an equivalently detected negotiation resistance is Rdet//R2. As a result, negotiation fails due to a large deviation from Rdec.

Based on discovery and analysis of the foregoing technical problems, the foregoing negotiation detection solutions in the conventional technology may cause a negotiation failure to a PD on which negotiation should have been successfully performed, or a risk of being damaged to a PD on which negotiation is successfully performed. In a word, negotiation stability and performance are poor.

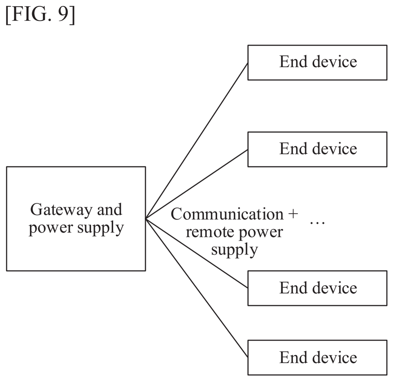

Based on the foregoing descriptions, FIG. 9 is a schematic of a PoE network deployment topology according to an embodiment of this application. The network topology includes a power supply gateway and a plurality of end devices. The gateway may be configured to provide functions of network communication and interconnection and power supply for one or more end devices, that is, both a communication function and remote power supply are implemented between the gateway and the end devices. Power sourcing equipment is generally an upstream device, for example, a network switch or an optical network unit (Optical Network Unit, ONU). A powered device is generally a downstream device, for example, a web camera, an internet protocol (Internet Protocol, IP) telephone, a radio AP, an advertising machine, a fax machine, or an access control client.

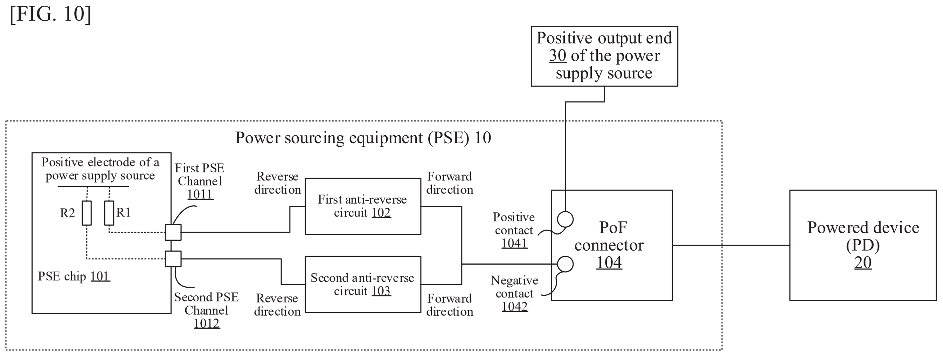

FIG. 10 is a schematic of a power supply connection in a PoF system according to an embodiment of this application. The PoF system includes two parts: power sourcing equipment PSE 10 and a powered device PD 20. The PSE 10 is a device that supplies power to an Ethernet client device, and is also a manager of an entire process of PoE power over Ethernet. The PSE 10 is responsible for injecting power into an Ethernet cable, planning and managing power, collecting voltages and currents at both ends of the powered device PD 20, and calculating a resistance of the powered device PD 20. The PD 20 is a PSE load that receives the power supply, that is, a client device of a PoE system, for example, an IP telephone, a network security camera, an AP, a personal digital assistant (PDA), a mobile phone charger, or many other Ethernet devices. An information relationship between a connection condition, a device type, a power consumption level, and the like of the PD 20 may be established between the PSE 10 and the PD 20 based on an IEEE 802.3bt standard, and the PSE 10 supplies power to the PD 20 via Ethernet based on the information relationship. The power sourcing equipment 10 may be located in any upstream device like a switch or a server, and the powered device 20 may be located in any downstream device like a camera or an AP. A hardware structure of the power sourcing equipment 10 may specifically be a chip, a chip set, or a circuit board equipped with a chip or a chip set. The chip, the chip set, or the circuit board equipped with the chip or the chip set may work when driven by necessary software. The following processes may be mainly included:

1. Detection: At the beginning, before supplying power to the PD 20, the PSE 10 first outputs a low voltage to detect whether the powered device (PD) complies with an IEEE 802.3af standard. If the powered device complies with the standard, a 24.9 K resistor is generally selected in the powered device, to confirm that the powered device complies with the IEEE 802.3af power supply standard.

2. Classification: After detecting a resistance that meets a requirement, the PSE further increases the output voltage to classify the powered device. If the powered device does not respond with a classification confirmation current at this time, the PSE classifies the powered device as a class 0 device by default and provides output power of 15.4 W for the powered device.

3. Power supply: After the classification is confirmed, the PSE outputs a direct current of 48 V to the powered device and confirms that the powered device meets a power requirement of not exceeding 15.4 W. When the powered device is overloaded or short-circuited, the PSE stops supplying power to the powered device and enters the detection phase again.

A power supply management function of the PSE is mainly implemented by a PSE chip 101. For example, 10 V, 6.3 V, and 3.3 V that are needed for an internal operation of the PSE chip 101 during running are generated by external power supply, each power supply port may provide a current up to 570 mA, and maximum power of 90 W may be provided for each PD. Optionally, the PSE chip 101 may measure a resistance, a voltage, and a current of each PSE channel, so that the power supply management function can be implemented more accurately.

As shown in FIG. 10, a hardware circuit of the power sourcing equipment PSE 10 mainly includes the PSE chip 101 and a peripheral circuit of the PSE chip 101. The power sourcing equipment PSE 10 shown in FIG. 10 includes the power sourcing equipment PSE chip 101, a first anti-reverse circuit 102, a second anti-reverse circuit 103, and a power over fiber PoF connector 104. The PSE chip 101 includes at least a first PSE channel 1011 and a second PSE channel 1012, where the PoF connector 104 includes a positive contact 1041 and a negative contact 1042, and the powered device PD 20 connected to the PoF connector 104 is connected between the positive contact 1041 and the negative contact 1042. The first PSE channel 1011 is connected to the negative contact 1042 through the first anti-reverse circuit 102, and the second PSE channel 1021 is connected to the negative contact 1042 through the second anti-reverse circuit 103. A reverse direction of the first anti-reverse circuit 102 is connected to the first PSE channel 1011, a forward direction of the first anti-reverse circuit 102 is connected to the negative contact 1042. A reverse direction of the second anti-reverse circuit 103 is connected to the second PSE channel 1012, and a forward direction of the second anti-reverse circuit 103 is connected to the negative contact 1042. The positive contact 1041 is connected to a positive output end 30 of a power supply source. When the first PSE channel 1011 performs first voltage detection on the PD 20, the second PSE channel 1012 is pulled up to a positive electrode of the power supply source by using an internal pull-up resistor R2, where R2 is equivalent to being connected in parallel with the PD 20, and the second anti-reverse circuit 103 is in a state of being conducted from the negative contact 1042 to the second PSE channel 1012 and being blocked from R2 to the negative contact 1042. Optionally, when the second PSE channel 1012 performs second voltage detection on the PD 20, the first PSE channel 1011 is pulled up to the positive electrode of the power supply source by using an internal pull-up resistor R1, where R1 is equivalent to being connected in parallel with the PD 20, and the first anti-reverse circuit 102 is in a state of being conducted from the negative contact 1042 to the first PSE channel 1011 and being blocked from R1 to the negative contact 1042.

It should be noted that the positive output end 30 of the power supply source and the positive electrode that is of the power supply source and that is a destination of the pull-up performed by the pull-up resistor R1 or R2 may belong to a same power supply network, that is, sizes are equal, but physical locations for power supply are different. For example, the physical locations for power supply belong to a same network, the positive output end that is of the power supply source and that is connected to the positive contact is outside the PSE chip or outside the power sourcing equipment PSE, and the positive electrode that is of the power supply source and that is connected to R1 or R2 is inside the PSE chip. This is not specifically limited in this embodiment of this application.

Optionally, the PSE chip 101 in the power sourcing equipment 10 in this embodiment of this application may include a plurality of groups of first PSE channels and second PSE channels. In other words, a schematic of a structure of the power sourcing equipment 10 in FIG. 10 merely shows a group of PSE channels (namely, the first PSE channel 1011 and the second PSE channel 1012) as an example. It may be understood that, each group of PSE channels are also correspondingly connected to corresponding anti-reverse circuits and a corresponding PoF connector. Details are not described herein again. In this embodiment of this application, related embodiments are described through a group of PSE channels and corresponding anti-reverse circuits and a corresponding PoF connector as an example.

It should be noted that, both the pull-up resistor R1 connected to the first PSE channel 1011 and the pull-up resistor R2 connected to the second PSE channel 1012 play a role in a negotiation detection phase of power supply. When the first PSE channel 1011 works and the second PSE channel 1012 is idle, R1 does not perform pull-up, and R2 performs pull-up to the positive electrode RTN of the power supply source. When the second PSE channel 1012 works and the first PSE channel 1011 is idle, R2 does not perform pull-up, and R1 performs pull-up to the positive electrode RTN of the power supply source. That the first PSE channel 1011 works means that the first PSE channel 1011 is in a negotiation detection phase at this time, and needs to detect a characteristic resistance Rdec of the powered device PD 20. In addition, the second PSE channel 1012 is in an idle state in which the second PSE channel 1012 is pulled up to the positive electrode RTN of the power supply source by using R2. Similarly, that the second PSE channel 1012 works means that the second PSE channel 1012 is in a negotiation detection phase at this time, and needs to detect the characteristic resistance Rdec of the powered device PD 20. In addition, the first PSE channel 1011 is in an idle state in which the first PSE channel 1011 is pulled up to the positive electrode RTN of the power supply source by using R1.

In a schematic of a structure of a circuit shown in FIG. 10, a current flows from the positive contact 1041 to the negative contact 1042 through the powered device 20, and finally flows to the first PSE channel 1011 through the first anti-reverse circuit 102 in a forward-to-reverse direction. Similarly, a current finally flows to the second PSE channel 1012 through the second anti-reverse circuit 103 in a forward-to-reverse direction. On the contrary, because the anti-reverse circuits in this embodiment of this application have a feature of forward conduction and reverse blocking, when the first PSE channel 1011 performs first voltage detection on the powered device PD 20 (in this case, R1 is not connected, but R2 is connected), each of the first anti-reverse circuit and the second anti-reverse circuit is in a state of forward → reverse conduction and reverse → forward blocking, that is, a state of forward-to-reverse conduction and reverse-to-forward blocking. In this case, R1 is not connected, but R2 is connected. Therefore, it is equivalent to that the idle second PSE channel 1012 is in a state of being blocked in a reverse direction (that is, a direction from R2 to the negative contact), thereby avoiding reverse impact of the idle channel, that is, the second PSE channel 1012, on the negotiation channel, that is, the first PSE channel 1011. Similarly, when the second PSE channel 1012 performs second voltage detection on the powered device PD 20 (in this case, R2 is not connected, but R1 is connected), each of the first anti-reverse circuit 102 and the second anti-reverse circuit 103 is in a state of forward → reverse conduction and reverse → forward blocking. In this case, R2 is not connected, but R1 is connected. Therefore, it is equivalent to that the idle first PSE channel 1011 is in a state of being blocked in a reverse direction (that is, a direction from the R2 to the negative contact), thereby avoiding reverse impact of the idle channel, that is, the first PSE channel 1011, on the negotiation channel, that is, the second PSE channel 1012. In this way, when the first PSE channel 1011 and the second PSE channel 1012 sequentially perform negotiation detection, it is ensured that both detected negotiation resistances are Rdet, and powering up can be normally performed.

The first PSE channel 1011 and the second PSE channel 1012 form one group of PSE power supply channels, and jointly supply power to the corresponding powered device 20. After the foregoing negotiation detection procedure is completed, the PSE power supply channels that include the first PSE channel 1011 and the second PSE channel 1012 may subsequently perform classification, powering up, real-time monitoring, power management, powering off, and the like on the powered device PD 20.

In the power sourcing equipment provided in this embodiment of this application, anti-reverse circuits (for example, the first anti-reverse circuit and the second anti-reverse circuit) are separately added between the first PSE channel, the second PSE channel, and the PoF connector, so that when the PSE chip is in a phase of performing negotiation detection on the powered device, forward conduction and reverse blocking can be implemented through the anti-reverse circuits. In this way, when a negotiation channel performs negotiation detection on the powered device, a pull-up resistor in an idle channel cannot be connected to the circuit in a reverse direction due to disposing of the anti-reverse circuit, thereby avoiding impact of the pull-up resistor on the negotiation channel detection, improving accuracy of the detection performed by the power sourcing equipment in the negotiation detection phase, and avoiding a power supply failure. This helps improve power supply stability of the power sourcing equipment.

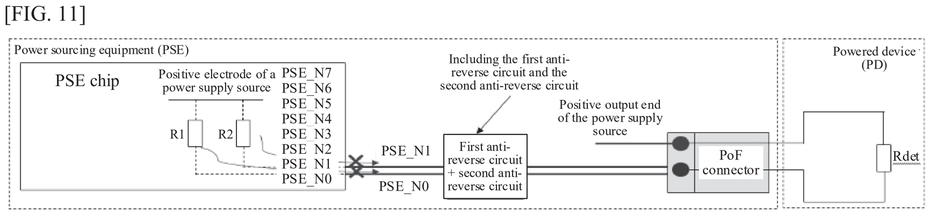

FIG. 11 is another schematic of a power supply connection in a PoF system according to an embodiment of this application. For example, a PSE chip includes eight ports, which may also be referred to as eight PSE channels: PSE-N0, PSE-N1, PSE-N2, PSE-N3, PSE-N4, PSE-N5, PSE-N6, and PSE-N7 in this embodiment of this application. It may be understood that the PSE chip is not limited to the eight channels, and may alternatively include 16 channels or more. This is not specifically limited in this embodiment of this application. The PSE chip is mainly configured to: manage a power supply process, and supply power to an optical and electrical hybrid cable according to an IEEE 802.3bt (PoE++) standard. Theoretically, each group of power supply channels may include two or more PSE channels. For example, eight separate power channels can be configured in any combination manner of two PSE channels (one group of power supply channels) or four PSE channels (two groups of power supply channels). The PSE chip may detect a powered device (PD) having a valid feature, determine a power supply requirement of the device based on a class of the powered device, and supply power. Each group of power supply channels (which may include two or more PSE channels) of the PSE chip is externally connected to one PoF connector (that is, corresponding to one network interface), the PoF connector is connected to one optical and electrical hybrid cable through a network interface, and the optical and electrical hybrid cable is connected to at least one powered device. When a PSE channel in a group of power supply channels is in a working state (in this case, a pull-up resistor is in a disconnected state, for example, when the PSE-N0 is in a working state, a corresponding R1 is in a disconnected state in this case), that is, when the PSE channel performs voltage detection negotiation on the powered device, another PES channel is in an idle state (in this case, a pull-up resistor is in a connected state, for example, when the PSE-N1 is in an idle state, a corresponding R2 is in a connected state in this case). Each group of power supply channels are configured to supply power to the at least one connected powered device PD. A PSE chip and anti-reverse circuits are connected in series between a positive electrode and a negative electrode of the PoF connector, so that a PSE channel (for example, an MOS transistor) on the PSE chip is controlled to provide a voltage difference, so as to control a magnitude of a voltage (or a current) of the powered device (that is, a load). It should be noted that R1 or R2 inside the PSE chip is in a negotiation detection procedure in a procedure of obtaining a power supply by the PD when the PD is connected to a PSE system.

In this embodiment of this application, an anti-reverse circuit is added to a PSE_N peripheral channel of a PSE chip of a circuit board. As shown in FIG. 11, anti-reverse circuits are actually added to equivalently isolate the PSE_N0 channel and the PSE_N1 channel into two independent channels through the circuits, so as to avoid reverse impact of an idle channel on a negotiation channel. In this way, when the PSE_N0 and the PSE_N1 sequentially perform negotiation detection, it is ensured that both detected negotiation resistances are Rdet, and powering up can be normally performed. A negotiation detection problem of a power over fiber unit in a PoE++ mode is resolved, and flexibility and competitiveness of product load are improved.

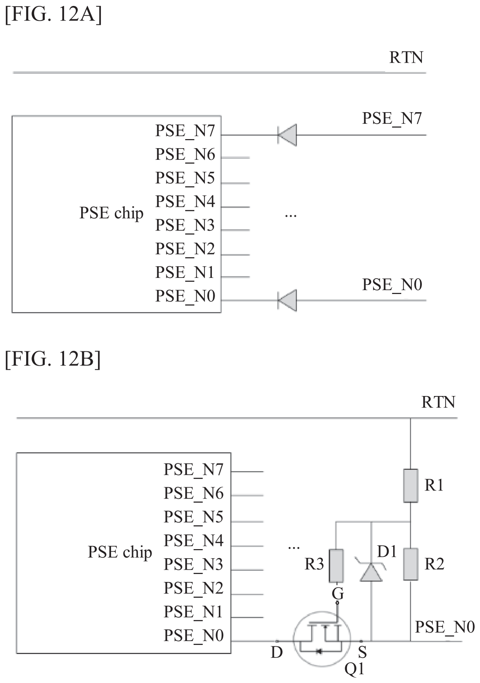

In a possible implementation, each of the first anti-reverse circuit 102 and the second anti-reverse circuit 103 is an anti-reverse circuit including a diode, where the forward directions of the first anti-reverse circuit 102 and the second anti-reverse circuit 103 each are an anode of the diode, and the reverse directions of the first anti-reverse circuit 102 and the second anti-reverse circuit 103 each are a cathode of the diode. FIG. 12A is a schematic of a structure of a diode anti-reverse circuit according to an embodiment of this application. A diode has a total of two working states: blocked and conducted, and there is a specific condition for the diode to be blocked and to be conducted. If a forward voltage applied to a positive electrode of the diode is higher than a negative voltage, which is equivalent to applying a forward-bias voltage to the diode, provided that the forward voltage reaches a specific value, the diode can be conducted. After being conducted, the diode is equivalent to a conductor, and a current flows from the positive electrode to a negative electrode of the diode. It should be noted that the diode anti-reverse does not need to be enabled, and an anti-reverse function is triggered provided that the current flows through the diode anti-reverse circuit. Each of the anti-reverse circuits in this embodiment of this application includes a diode, and unidirectional conduction between the PSE channel and the PoF connector is implemented based on unidirectional conductivity performance of the diode. The unidirectional conductivity performance does not need to be enabled, the circuit is simple, and costs are low. An anode of the diode is used as a forward direction of the anti-reverse circuit, and a cathode of the diode is used as a reverse direction of the anti-reverse circuit.

In a possible implementation, each of the first anti-reverse circuit 102 and the second anti-reverse circuit 103 is an anti-reverse circuit including a metal-oxide-semiconductor MOS transistor, where the forward directions of the first anti-reverse circuit 102 and the second anti-reverse circuit 103 each are a source of the MOS transistor, and the reverse directions of the first anti-reverse circuit 102 and the second anti-reverse circuit 103 each are a drain of the MOS transistor. FIG. 12B is a schematic of a structure of an MOS transistor anti-reverse circuit according to an embodiment of this application. There is a conductive impedance in an MOS transistor, that is, RDS(on) that is a conductive impedance between a drain and a source. At a moment of powering up, the MOS is saturated and conducted in a forward connection case, and the MOS cannot be conducted in a reverse connection case. Therefore, an anti-reverse function is implemented. D1 is a regulator diode, and may be configured to prevent the MOS transistor from being broken down due to an excessively high gate-source voltage. R1 and R2 may be configured to perform voltage division on the MOS transistor, and R3 may be configured to perform current limiting. It should be noted that the MOS transistor anti-reverse circuit does not need to be enabled, and an anti-reverse function is triggered provided that a current flows through the MOS transistor anti-reverse circuit. Each of the anti-reverse circuits in this embodiment of this application includes an MOS transistor. Unidirectional conduction between the PSE channel and the PoF connector is implemented based on a characteristic that the MOS transistor is conducted when a power supply is normally connected, and the MOS transistor is blocked when the power supply is reversely connected. In other words, Vgs is used to control conduction and disconnection of the MOS. A source of the MOS transistor is used as a forward direction of the anti-reverse circuit, and a drain of the MOS transistor is used as a reverse direction of the anti-reverse circuit. In addition, because power consumption of the conduction of the MOS transistor is low, circuit power consumption may be further reduced. Optionally, the first anti-reverse circuit 102 or the second anti-reverse circuit 103 further includes one or more of a voltage divider resistor, a current-limiting resistor, and a regulator diode that are connected to the MOS transistor. In this embodiment of this application, when each of the anti-reverse circuits includes an MOS transistor, alternatively, one or more of a related voltage divider resistor, a related current-limiting resistor, and a related regulator diode may be disposed in the anti-reverse circuit, to stabilize a voltage on the MOS transistor, so as to better implement a unidirectional conduction function.

In a possible implementation, the first PSE channel 1011 and the second PSE channel 1012 form one group of power supply channels, and the power supply channel is configured to perform detection, classification, powering up, monitoring, or power management on the PD 20. In this embodiment of this application, power is supplied to the powered device through the power supply channels that include the first PSE channel and the second PSE channel. Further, related functions such as negotiation detection, classification, powering up, monitoring, or power management may be provided for the powered device.

In a possible implementation, the power supply source is configured to provide an initial voltage between the positive contact 1041 and the negative contact 1042. The first PSE channel 1011 is configured to regulate the initial voltage between the positive contact 1041 and the negative contact 1042 to a first detection voltage. Alternatively, the second PSE channel 1021 is configured to regulate the initial voltage between the positive contact 1041 and the negative contact 1042 to a second detection voltage. It may be understood that, the initial voltage provided by the power supply source is an initial voltage in the negotiation detection phase, and voltages provided by the power supply source may be different in different phases such as a classification phase, a powering up phase, a monitoring phase, and a management phase. Details are not listed one by one herein. In this embodiment of this application, in the negotiation detection phase in which power is supplied to the powered device, corresponding detection voltages are separately provided for the powered device through the first PSE channel and the second PSE channel, to obtain a detection resistance of the powered device through measurement.

In a possible implementation, the PSE chip further includes a plurality of groups of power supply channels, and each group of power supply channels include at least the first PSE channel and the second PSE channel. The power sourcing equipment further includes a first anti-reverse circuit, a second anti-reverse circuit, and a power over fiber PoF connector that correspond to each group of power supply channels. In this embodiment of this application, the PSE chip may include a plurality of PSE channels, and at least two PSE channels form one group of power supply channels to supply power to the corresponding power sourcing equipment. In addition, correspondingly, the first PSE channel and the second PSE channel in each of the plurality of groups of power supply channels are also connected to a corresponding first anti-reverse circuit and second anti-reverse circuit, and a corresponding PoF connector.

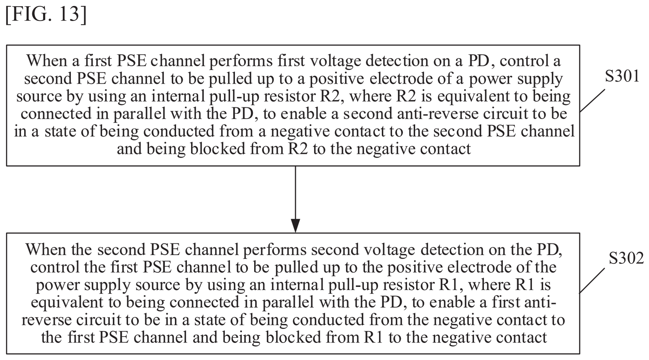

FIG. 13 is a schematic flowchart of a power supply method according to an embodiment of this application. The method may be applied to the power sourcing equipment shown in FIG. 10 or FIG. 11. The power sourcing equipment may specifically include a power sourcing equipment PSE chip, a first anti-reverse circuit, a second anti-reverse circuit, and a power over fiber PoF connector. The PSE chip includes a first PSE channel and a second PSE channel. The PoF connector includes a positive contact and a negative contact, and a powered device PD connected to the PoF connector is connected between the positive contact and the negative contact. The first PSE channel is connected to the negative contact through the first anti-reverse circuit, and the second PSE channel is connected to the negative contact through the second anti-reverse circuit, where a reverse direction of the first anti-reverse circuit is connected to the first PSE channel, a forward direction of the first anti-reverse circuit is connected to the negative contact, a reverse direction of the second anti-reverse circuit is connected to the second PSE channel, and a forward direction of the second anti-reverse circuit is connected to the negative contact. The positive contact is connected to a positive output end of a power supply source. The power supply method may include the following step S301, and optionally, may further include step S302.

Step S301: When the first PSE channel performs first voltage detection on the PD, control the second PSE channel to be pulled up to a positive electrode of the power supply source by using an internal pull-up resistor R2, where R2 is equivalent to being connected in parallel with the PD, to enable the second anti-reverse circuit to be in a state of being conducted from the negative contact to the second PSE channel and being blocked from R2 to the negative contact.

Step S302: When the second PSE channel performs second voltage detection on the PD, control the first PSE channel to be pulled up to the positive electrode of the power supply source by using an internal pull-up resistor R1, where R1 is equivalent to being connected in parallel with the PD, to enable the first anti-reverse circuit to be in a state of being conducted from the negative contact to the first PSE channel and being blocked from R1 to the negative contact.

It should be noted that, for a specific procedure of a power supply method of multipath power sourcing equipment described in embodiments of this application, refer to related descriptions in the embodiments of this application in FIG. 9 to FIG. 12B. Details are not described herein again.

In the foregoing embodiments, the descriptions of embodiments have respective focuses. For a part that is not described in detail in an embodiment, refer to related descriptions of another embodiment.

It should be noted that, for brief description, the foregoing method embodiments are represented as a series of action combinations. However, persons skilled in the art should understand that this application is not limited to the described action sequence, because some steps may be performed in other sequences or simultaneously according to this application. It should be further appreciated by persons skilled in the art that embodiments described in this specification all belong to example embodiments, and the involved actions and modules are not necessarily required by this application.

In the several embodiments provided in this application, it should be understood that the disclosed apparatus may be implemented in other manners. For example, the foregoing described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical or other forms.

The foregoing units described as separate parts may or may not be physically separate, and parts displayed as units may or may not be physical units, that is, may be located in one position, or may be distributed on a plurality of network units. Some or all of the units may be selected based on actual needs to achieve the objectives of the solutions of embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the foregoing integrated unit is implemented in the form of the software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in a form of a software product. The computer software product is stored in a storage medium and includes several instructions for instructing a computer device (which may be a personal computer, a server, a network device, or the like, and may be specifically a processor in the computer device) to perform all or some of the steps of the method in embodiments of this application. The foregoing storage medium may include any medium that can store program code, such as a USB flash drive, a mobile hard disk, a magnetic disk, an optical disc, a read-only memory (Read-Only Memory, ROM for short), or a random access memory (Random Access Memory, RAM for short).

The foregoing embodiments are merely intended for describing the technical solutions of this application rather than limiting this application. Although this application is described in detail with reference to the foregoing embodiments, persons of ordinary skill in the art should understand that they may still make modifications to the technical solutions described in the foregoing embodiments or make equivalent replacements to some technical features thereof. Such modifications or replacements do not make the essence of the corresponding technical solutions depart from the spirit and scope of the technical solutions of embodiments of this application.

**Claims**

1. Power sourcing equipment, comprising a power sourcing equipment, PSE, chip, a first anti-reverse circuit, a second anti-reverse circuit, and a power over fiber, PoF, connector, wherein the PSE chip comprises a first PSE channel and a second PSE channel;

   the PoF connector comprises a positive contact and a negative contact, a powered device, PD, connected to the PoF connector is connected between the positive contact and the negative contact, the first PSE channel is connected to the negative contact through the first anti-reverse circuit, the second PSE channel is connected to the negative contact through the second anti-reverse circuit, a reverse direction of the first anti-reverse circuit is connected to the first PSE channel, a forward direction of the first anti-reverse circuit is connected to the negative contact, a reverse direction of the second anti-reverse circuit is connected to the second PSE channel, a forward direction of the second anti-reverse circuit is connected to the negative contact, and the positive contact is connected to a positive output end of a power supply source; and
   when the first PSE channel performs first voltage detection on the PD, the second PSE channel is pulled up to a positive electrode of the power supply source by using an internal pull-up resistor R2, wherein R2 is equivalent to being connected in parallel with the PD, and the second anti-reverse circuit is in a state of being conducted from the negative contact to the second PSE channel and being blocked from R2 to the negative contact.

2. The power sourcing equipment according to claim 1, wherein when the second PSE channel performs second voltage detection on the PD, the first PSE channel is pulled up to the positive electrode of the power supply source by using an internal pull-up resistor R1, wherein R1 is equivalent to being connected in parallel with the PD, and the first anti-reverse circuit is in a state of being conducted from the negative contact to the first PSE channel and being blocked from R1 to the negative contact.

3. The power sourcing equipment according to claim 1, wherein each of the first anti-reverse circuit and the second anti-reverse circuit is an anti-reverse circuit comprising a diode, wherein the forward directions of the first anti-reverse circuit and the second anti-reverse circuit each are an anode of the diode, and the reverse directions of the first anti-reverse circuit and the second anti-reverse circuit each are a cathode of the diode.

4. The power sourcing equipment according to claim 1, wherein each of the first anti-reverse circuit and the second anti-reverse circuit is an anti-reverse circuit comprising a metal-oxide-semiconductor MOS transistor, wherein the forward directions of the first anti-reverse circuit and the second anti-reverse circuit each are a source of the MOS transistor, and the reverse directions of the first anti-reverse circuit and the second anti-reverse circuit each are a drain of the MOS transistor.

5. The power sourcing equipment according to claim 4, wherein the first anti-reverse circuit or the second anti-reverse circuit further comprises one or more of a voltage divider resistor, a current-limiting resistor, and a regulator diode that are connected to the MOS transistor.

6. The power sourcing equipment according to claim 1, wherein the first PSE channel and the second PSE channel form one group of power supply channels, and the power supply channel is configured to perform detection, classification, powering up, monitoring, or power management on the PD.

7. The power sourcing equipment according to claim 1, wherein the power supply source is configured to provide an initial voltage between the positive contact and the negative contact; and

   the first PSE channel is configured to regulate the initial voltage between the positive contact and the negative contact to the first detection voltage; or
   the second PSE channel is configured to regulate the initial voltage between the positive contact and the negative contact to the second detection voltage.

8. The power sourcing equipment according to claim 1, wherein the PSE chip further comprises a plurality of groups of power supply channels, and each group of power supply channels comprise at least the first PSE channel and the second PSE channel; and
   the power sourcing equipment further comprises a first anti-reverse circuit, a second anti-reverse circuit, and a power over fiber PoF connector that correspond to each group of power supply channels.

9. A power supply method, applied to power sourcing equipment, wherein the power sourcing equipment comprises a power sourcing equipment PSE chip, a first anti-reverse circuit, a second anti-reverse circuit, and a power over fiber PoF connector, wherein the PSE chip comprises a first PSE channel and a second PSE channel, the PoF connector comprises a positive contact and a negative contact, a powered device PD connected to the PoF connector is connected between the positive contact and the negative contact, the first PSE channel is connected to the negative contact through the first anti-reverse circuit, the second PSE channel is connected to the negative contact through the second anti-reverse circuit, a reverse direction of the first anti-reverse circuit is connected to the first PSE channel, a forward direction of the first anti-reverse circuit is connected to the negative contact, a reverse direction of the second anti-reverse circuit is connected to the second PSE channel, a forward direction of the second anti-reverse circuit is connected to the negative contact, and the positive contact is connected to a positive output end of a power supply source; and the method comprises:

when the first PSE channel performs first voltage detection on the PD, controlling the second PSE channel to be pulled up to a positive electrode of the power supply source by using an internal pull-up resistor R2, wherein R2 is equivalent to being connected in parallel with the PD, to enable the second anti-reverse circuit to be in a state of being conducted from the negative contact to the second PSE channel and being blocked from R2 to the negative contact.

10. The method according to claim 9, wherein the method further comprises:
when the second PSE channel performs second voltage detection on the PD, controlling the first PSE channel to be pulled up to the positive electrode of the power supply source by using an internal pull-up resistor R1, wherein R1 is equivalent to being connected in parallel with the PD, to enable the first anti-reverse circuit to be in a state of being conducted from the negative contact to the first PSE channel and being blocked from R1 to the negative contact.

11. A power supply system, comprising the power sourcing equipment PSE according to any one of claims 1 to 8 and the powered device PD, wherein
the power sourcing equipment PSE supplies power to the powered device, the power sourcing equipment PSE is a network switch or an optical network unit ONU, and the powered device PD is a camera, an internet protocol IP telephone, a fax machine, or a radio access point AP.

[FIG. 1A]

Solution A

[FIG. 1B]

Solution B

[FIG. 2]

[FIG. 3]

[FIG. 4]

Power sourcing equipment (PSE)

Powered device (PD)

Vdet

Rdet

Isolation

DC/DC

Direct current chopper

[FIG. 5]

Powered device PD

| Non-valid detection signature | Non-compliant detection signature | Valid detection signature | Non-compliant detection signature | Non-valid detection signature | Effective resistance |

0 — 12 K — 23.7 K — 26.3 K — 45 K (25 K)

Power sourcing equipment PSE

| Shall reject Rbad | Accept or reject | Shall accept Rgood | Accept or reject | Shall reject Rbad | Effective resistance |

0 — 15 K — 19 K — 26.5 K — 33 K

[FIG. 6]

Single power supply device load (Single PD load)

Det:
Negotiation
detection

Channel A | Det | | Class | PwrUp

Class:
Classification

Channel B | Det | PwrUp

PwrUp:
Powering up

tcc2det | Tdet | tdet2det | Tdet | Tpon

[FIG. 7]

[FIG. 8]

EP 4 648 244 A1

[FIG. 9]

EP 4 648 244 A1

[FIG. 10]

[FIG. 11]

[FIG. 12A]

RTN

PSE chip

| | |
|---|---|
| PSE_N7 | PSE_N7 |
| PSE_N6 | |
| PSE_N5 | |
| PSE_N4 | ... |
| PSE_N3 | |
| PSE_N2 | |
| PSE_N1 | |
| PSE_N0 | PSE_N0 |

[FIG. 12B]

RTN

PSE chip

R1

PSE_N7
PSE_N6
PSE_N5
PSE_N4    ...    R3    D1    R2
PSE_N3
PSE_N2         G
PSE_N1
PSE_N0      D    S    PSE_N0
                Q1

[FIG. 13]

> When a first PSE channel performs first voltage detection on a PD, control a second PSE channel to be pulled up to a positive electrode of a power supply source by using an internal pull-up resistor R2, where R2 is equivalent to being connected in parallel with the PD, to enable a second anti-reverse circuit to be in a state of being conducted from a negative contact to the second PSE channel and being blocked from R2 to the negative contact

S301

> When the second PSE channel performs second voltage detection on the PD, control the first PSE channel to be pulled up to the positive electrode of the power supply source by using an internal pull-up resistor R1, where R1 is equivalent to being connected in parallel with the PD, to enable a first anti-reverse circuit to be in a state of being conducted from the negative contact to the first PSE channel and being blocked from R1 to the negative contact

S302

## INTERNATIONAL SEARCH REPORT

| International application No. |
|---|
| **PCT/CN2024/074044** |

| A. | CLASSIFICATION OF SUBJECT MATTER |
|---|---|

H02J1/08(2006.01)i; H04L12/10(2006.01)i

According to International Patent Classification (IPC) or to both national classification and IPC

| B. | FIELDS SEARCHED |
|---|---|

Minimum documentation searched (classification system followed by classification symbols)

IPC: H02J, H04L

Documentation searched other than minimum documentation to the extent that such documents are included in the fields searched

Electronic data base consulted during the international search (name of data base and, where practicable, search terms used)

CNTXT, WPABS, ENTXT, ENTXTC, DWPI, CNKI: PoE, 以太网, 供电, 设备, 装置, 系统, 受电, PSE, PD, 光电复合缆, PoF, 连接器, 网口, 接口, 防反, 隔离, 二极管, 晶体管, MOS, FET, 场效应, 电压, 检测, 协商, 握手, 上拉, 电阻, 阻抗, ethernet, power, equipment, device, system, powered, photoelectric w composite w cable, connector, interface, anti w reverse, isolate, diode, transistor, field w effect, voltage, detect, consult, negotiation, handshake, pull w up, resistor, impedance

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 110417559 A (HUAWEI TECHNOLOGIES CO., LTD.) 05 November 2019 (2019-11-05) description, paragraphs 2-50, and figures 1-6 | 1-11 |
| A | CN 113726530 A (XIDIAN UNIVERSITY) 30 November 2021 (2021-11-30) entire document | 1-11 |
| A | CN 106655385 A (SHENZHEN CLOU ELECTRONICS CO., LTD.) 10 May 2017 (2017-05-10) entire document | 1-11 |
| A | CN 208112643 U (SHENZHEN FEIYANG JIEXIN ELECTRONIC TECHNOLOGY CO., LTD.) 16 November 2018 (2018-11-16) entire document | 1-11 |
| A | CN 111245628 A (BEIJING HUAXIN AOTIAN NETWORK TECHNOLOGY CO., LTD.) 05 June 2020 (2020-06-05) entire document | 1-11 |

☑ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| **12 April 2024** | **15 April 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| | International application No. |
|---|---|
| | **PCT/CN2024/074044** |

**C.      DOCUMENTS CONSIDERED TO BE RELEVANT**

| Category* | Citation of document, with indication, where appropriate, of the relevant passages | Relevant to claim No. |
|---|---|---|
| A | US 2015019884 A1 (LINEAR TECHNOLOGY CORP.) 15 January 2015 (2015-01-15) entire document | 1-11 |

**INTERNATIONAL SEARCH REPORT**
**Information on patent family members**

International application No.

**PCT/CN2024/074044**

| Patent document cited in search report | | | Publication date (day/month/year) | Patent family member(s) | | | Publication date (day/month/year) |
|---|---|---|---|---|---|---|---|
| CN | 110417559 | A | 05 November 2019 | None | | | |
| CN | 113726530 | A | 30 November 2021 | None | | | |
| CN | 106655385 | A | 10 May 2017 | None | | | |
| CN | 208112643 | U | 16 November 2018 | None | | | |
| CN | 111245628 | A | 05 June 2020 | None | | | |
| US | 2015019884 | A1 | 15 January 2015 | US | 9419807 | B2 | 16 August 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310225191